# EUROPEAN PATENT SPECIFICATION

(11) **EP 2 568 782 B1**
(45) Date of publication and mention of the grant of the patent: **23.07.2014**
(21) Application number: 11306134.5
(22) Date of filing: 12.09.2011
(51) Int. Cl.: H05K 1/18, H05K 13/04, G06K 19/077, H05K 3/30

(54) **Tool and method for embedding a module in a data carrier**
Werkzeug und Verfahren zur Einbettung eines Moduls in einen Datenträger
Outil et procédé pour intégrer un module dans un support de données

(43) Date of publication of application: 13.03.2013
(73) Proprietor: Oberthur Technologies, 92300 Levallois-Perret (FR)
(72) Inventor: Simonneaux, Grégory, 92000 Nanterre (FR); Denecheau, Yannick, 92000 Nanterre (FR)
(74) Representative: Delumeau, François Guy

(56) References cited:
- EP-A1- 1 033 677
- EP-A2- 0 763 798
- JP-A- 58 218 136
- US-A- 4 799 617

## Description

### Field of the Invention

The invention relates to a tool and method of embedding a module in a data carrier. In particular, but not exclusively the module is a chip module that is embedded in a data carrier such as a credit card or smart card.

### Background of the Invention

Data carrier cards such as smart cards are made by laminating a layered structure, typically of plastic composite materials under pressure and heat. The card has an inner layer with a recess for receiving at least one chip module and in the case of contactless smart cards, at least one antenna coil. In the case of banking cards, for example, an outer protective layer on both sides of the inner layer.

To achieve a smooth, flat surface for a chip card, the recess in the inner layer is adapted as closely as possible to the dimensions of the chip module. The inner layer is generally composed of two individual layers. According to known chip card manufacturing processes, individual layers are punched with recesses and are aligned exactly with one another and are thermally connected to each other before the chip module and the coil can be inserted into the recess. Alternatively the recess may be milled from layers of laminated sheets that have been bonded together and which make up the card. The recess is dictated by the thickness of the card and as the cards are thin in cross section the chip modules themselves are thin. Furthermore the chip module has an irregular surface as there are contacts on the surface of the chip module and the metal contacts on the chip module are also vulnerable to damage so they need to be handled carefully.

As the chip modules are delicate, for ease of handling they are provided to card manufacturers on tapes to which the chip modules have been adhered. The tape is fed through a chip embedding machine where the chip modules are removed from the tape by punching through the tape and the chip module is then moved into a recess in a card as the cards also pass through the embedding machine. Typically the recess or the module has adhesive on a surface forming the base of the recess and this adhesive is heated before the module and the card recess are brought into contact so there is a good bond between the two. Currently punching involves a die which contacts the majority of the face of the chip module and there may be damage to the metal on the face of the chip module so causing pitting. Pitting is detrimental to the chip as it may alter its conductivity and also as it creates unevenness on the chip module surface it is not possible to print accurately on the chip module and so the card will have to be discarded. JP- 58218136 discusses a simple suction cut protruding from a face having a boundary defined by a collet. The collet is simply a periphery of the suction cup. US 4789617 again describe a suction cup that protrudes from the face of a tool and there is no contact as such between the tool itself and the module. EP 1033677 is even more removed from the invention in that it simply describes the use of suction to hold a module.

The current invention seeks to overcome the problems associated with the prior art by providing a new tool and method to insert chip modules or other entities having vulnerable surface, such as hologram carriers into a data carrier such as a credit card.

### Summary of the Invention

According to a first aspect of the present invention there is provided a tool for inserting a module in a data carrier, wherein said tool is provided with a face having a suction cup provided in a central region of said face, characterised in that said face also has a plurality of raised areas positioned around the said suction cup which can press a card that is held on the face into position on a data carrier.

Preferably the face of the tool is provided as a rectangular face conforming to the dimensions of the module to be inserted.

It is preferred that the module is a chip module to be inserted in data carrier in the form of a smart card.

It is envisaged that the face is of a substantially rectangular shape.

Preferably the raised areas are positioned between corners where perimeter edges of the rectangular shape forming the face meet.

In a preferred arrangement the raised areas are in the form of semi-circular raised areas which have a liner edge that aligns with edges of the perimeter edges of the face and the semi-circular edge of the raised areas extend towards the suction cup in the face.

Preferably the suction cup is made from a thermally resistant material, in particular a silicone type material.

According to a second aspect of the present invention there is provided a method of embedding a module in a data carrier having a recess that is formed in a face of the data carrier, according to claim 7.

Preferably the method involves heat treating said module prior to being inserted in the data carrier.

It is envisaged that the heat treatment involves blowing heated air over the surface of the module that is to come into contact with the data carrier.

In a preferred arrangement the method involves blowing a gas onto the surface of the module prior to said module being contacted by the suction cup to remove any debris from the surface of the module.

It is preferred that when the module is placed in the recess, pressure is placed on the tool, which has raised surfaces to push the module into the recess.

### Brief Description of the Figures

An embodiment of the invention will be described with reference to and as illustrated in the accompanying figures by way of example only, in which:
Figure 1 shows: a view of a chip module where there has been pitting of the surface as a result of using known tools; and
Figure 2 shows: a view of a tool according to an embodiment of the invention for placing a chip module in a data carrier.

### Detailed Description of Embodiments of the Invention

Typically data carriers are in the form of ID-1 format cards (derived from ISO Standard 78 10) which are used for bank cards and credit cards, for example.

The cards are typically made of plastic, plastic composites, for example with a paper or paper and glue composites. For plastic cards, the inner layer and the outer layers can consist of any laminated thermoplastic, such as PVC (polyvinylchloride), PET (polyethylene terephthalate), PBT (polybutylene terephthalate), ABS (acrylonitrile-butadiene-styrene), PC (polycarbonate), polyethylene, polypropylene, nylon or PMMA (Polymethmethacrylate). The inner and outer layers may comprise the same or different plastics. The thickness of the inner layer 2 can for example 1 mm or less, the thickness of the outer layers 1 and 13, for example 100 microns (100 µm) or less.

One or both of the two outer layers may be composed of several individual layers that can be also connected together during the lamination process. Also, multiple chip modules and/or antennas in one or more recesses of the inner layer may be provided. A punched recess is preferably arranged on the inner layer, then, the chip module is placed in the recess and for example a foamable plastic composition is fixed at the same time. The foamable plastic may have adhesive properties and cushioning properties to ensure that the chip module is securely retained in the recess. The upper opening of the recess is closed with the second layer and the whole layer arrangement is laminated. Laminating is by using a conventional laminating press with heated platens or rollers are given. The laminating temperature depends on the softening properties of the plastic material of the individual layers of the layered structure and of the foaming of the foamable mass. Typical temperatures used are 130 to 190 ° C. To obtain a smooth surface, the laminating pressure increased during cooling. It is also possible to compress the map after the hot lamination in a cold press at elevated pressure. The resultant blank cards can then be punched out to provide the final card format. The card can then be printed for personalizing and also the card surface may be optionally provided with a transparent protective layer.

The chip modules are supported on a tape (typically by being adhered to the tape) and the modules are punched out of the tape and moved into a recess in a card. The chip modules may have an adhesive coating (or the adhesive coating may be provided by the tape from which the module is punched) and there may also be a foamable material in the recess in the card into which the chip module is to be placed. Typically the chips are moved towards the card recess using dies that contact the majority of the face of the chip module and because there is adhesive from the chip carrier and also adhesive can be picked up from the die when it transfers from one insertion process to the next, then the die can itself become contaminated with glue particles and also with particles that are in the air and which attach to the glue on the die. This means that the die surface can have raised areas of contamination. When a dirty die picks up a fresh chip module and presses it into a recess in the data carrier, then any dirt can impact on the surface of the chip module and damage it by pitting the surface. Basically residues are coming from the module punching tool, especially on module corners where punching tolerance are weaker.

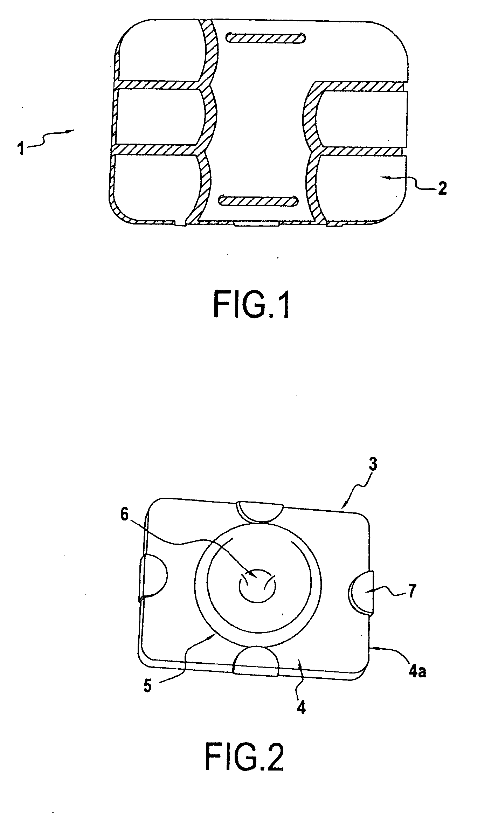

Figure 1 shows a chip module generally shown as I with pitting 2 in the metal surface of the module.

Figure 2 shows a tool according to the invention which overcomes the risk of pitting of a chip module.

A tool is generally shown as 3 in Figure 2. The tool is rectangular is shape and has a face 4 with sides, such a side 4a. Towards a central region of the face there is a suction area, 5 formed by a suction cup which in this embodiment is shown as a round suction cup. Although the cup shown is circular in shape it may be of any dimensions or shape. The suction cup ideally provides enough force to support a module such as a chip module. The suction is provided by aperture 6 which leads to a suction device (not shown). The aperture may also be used to blow gas or air onto a surface to clean it before applying suction. The suction cup is preferably made from silicone as it has heat resistant properties which is advantageous as heat is applied to the chip module (typically the part of the chip module that sits in the recess in a data carrier) to activate adhesive on the module or to cause the module to be hot enough to activate adhesive that may have been positioned in the recess of the card prior to positioning the chip module. The adhesive is heated so it is pre-activated before insertion of the chip module in the recess and hot air is typically used where there is blowing of hot air (250°C) under the module (held by this cup).

The tool used is typically a nickel-based composite layer electrochemically deposited on steel. The adhesion coefficient of current dies is typically 1.5 but by changing the material used to a material such as ASP23 which is a 60/64 hardened chromium-molybdenum-tungsten-vanadium alloyed high speed steel which is characterized by high wear resistance this gives an adhesion coefficient of 0.34. The steel may also be coated with a microparticle coating combining Aluminum, Chromium and Nitrogen to further improve the surface characteristics of the steel such as hardness.

The tool has raised areas 7 that are positioned between the corners of the tool. These raised areas as shown are semi-circular in shape so that pressure is evenly distributed towards the periphery of the module and also there are no sharp edges which could damage the surface of the module. The raised areas are substantially equidistant between the corners of the tool. The use of the raised areas at such a location surprisingly avoids pitting because when punching the module from the carrier tape, the weakest punch point is at the corners of the punch tool and by moving the raised areas, there is adequate pressure transmitted to the module to insert it in the recess while avoiding pitting damage which often occurs towards the corner of the module as shown in Figure 1.

To embed a module in a data carrier such as a card, conventional processes are used to make the recess. The surface of the module is cleaned, preferably by blowing a gas over the surface either with the tool of the invention where a gas such as air is blown though the aperture 6 or a gas from a separate source may be blown across the module surface to ensure that any debris is removed. The tool is then brought into contact with the face of the module and suction applied to secure the module to the tool and then the tool is moved towards the recess with force being applied on the tool when the module is in position. The tool may have a heating element to heat the module or a heat source may apply heat to the rear of the module to activate adhesive that is in situ or to provide a hot surface that can activate adhesive that is in the recess on the data carrier. The force is applied such that the module is securely inserted in the recess and pressure is applied by raised areas 7 in combination with pressure from the central area of the tool where the suction cup is. The combination of both of these elements applies a gentle force to secure the module without damage. Although the invention has been discussed in the main in relation to chip modules, it could be applied to the insertion of any other insert into a data carrier, for example hologram modules

It is to be understood that the above embodiments have been provided only by way of exemplification of this invention, such as those detailed below, and that further modifications and improvements thereto would be apparent to persons skilled in the relevant art, which fall within the scope defined by the claims.

## Claims

1. A tool (3) for inserting a module (1) in a data carrier, wherein said tool is provided with a face (4) having a suction cup (5) provided in a central region of said face, **characterised in that** said face also has a plurality of raised areas (7) positioned around said suction cup which can press a module that is held on the face into position on a data carrier.

2. A tool (3) according to claim 1, wherein the face (4) of the tool is provided as a rectangular face conforming to the dimensions of the module to be inserted.

3. A tool (3) according to claim 1 or claim 2, wherein the face (4) is of a substantially rectangular shape.

4. A tool (3) according to claim 3, wherein the raised areas (7) are positioned at a location substantially equidistant between corners of a perimeter edge (4a) of the rectangular shaped face (4).

5. A tool (3) according to claim 4, wherein the raised areas (7) are in the form of semi-circular raised areas, each raised area having a linear edge that is aligned with a perimeter edge (4a) of the face (4) and the semi-circular edge of the raised areas extend towards the suction cup (5) in the face.

6. A tool (3) according to any preceding claim wherein the suction cup (5) is made from a thermally resistant material, in particular a silicone type material.

7. A method of embedding a module in a data carrier, said data carrier having a recess that is formed in a face of the data carrier, wherein said module is removed from a module support by using a tool (3) according to claim 1 having a suction cup (5) that holds the module, the tool (3) is brought into proximity to the recess, **characterised in that** the suction cup holds the module in position in the recess of the data carrier and the raised areas of the tool (3) positioned around the suction cup transmit force to the module to press said module into the recess without force being applied to the corners of the module.

8. A method according to claim 7, wherein the module is heat treated prior to being inserted in the data carrier.

9. A method according to claim 8 wherein the heat treatment involves blowing heated air over the surface of the module that is to come into contact with the data carrier.

10. A method according to any of claims 7 to 9 involving blowing a gas onto the surface of the module prior to said module being contacted by the suction cup to remove any debris from the surface of the module.

## Patentansprüche

1. Instrument (3) zum Einsetzen eines Moduls (1) in einen Datenträger, wobei das Instrument mit einer Oberfläche (4) versehen ist, die einen in einem mittleren Bereich der Oberfläche vorgesehenen Saugnapf (5) aufweist, **dadurch gekennzeichnet, dass** die Oberfläche auch mehrere, um den Saugnapf herum positionierte erhöhte Bereiche (7), aufweist, die ein auf der Oberfläche gehaltenes Modul auf einem Datenträger in Position drücken können.

2. Instrument (3) nach Anspruch 1, wobei die Oberfläche (4) des Instruments als rechteckige Oberfläche, die den Maßen des einzusetzenden Moduls entspricht, bereitgestellt wird.

3. Instrument (3) nach Anspruch 1 oder 2, wobei die Oberfläche (4) eine im Wesentlichen rechteckige Form hat.

4. Instrument (3) nach Anspruch 3, wobei die erhöhten Bereiche (7) an einer Stelle positioniert sind, die im Wesentlichen äquidistant zu den Ecken eines Umfangsrandes (4a) der rechteckig geformten Oberfläche (4) ist.

5. Instrument (3) nach Anspruch 4, wobei die erhöhten Bereiche (7) als halbrunde erhöhte Bereiche geformt sind, wobei jeder erhöhte Bereich einen geraden Rand hat, der an einen Umfangsrand (4a) der Oberfläche (4) angepasst ist, und der halbrunde Rand der erhöhten Bereiche sich in Richtung des Saugnapfes (5) auf der Oberfläche erstreckt.

6. Instrument (3) nach einem der vorhergehenden Ansprüche, wobei der Saugnapf (5) aus einem hitzebeständigen Material, insbesondere einem Siliziummaterial, besteht.

7. Verfahren zum Einbetten eines Moduls in einen Datenträger, der eine in einer Oberfläche des Datenträgers ausgebildete Vertiefung aufweist, wobei das Modul aus einem Modulträger mithilfe eines Instruments (3) nach Anspruch 1, welches einen das Modul haltenden Saugnapf (5) aufweist, entfernt wird, das Instrument (3) in die Nähe der Vertiefung gebracht wird, **dadurch gekennzeichnet, dass** der Saugnapf das Modul in der Vertiefung des Datenträgers in Position hält und die um den Saugnapf herum positionierten erhöhten Bereiche des Instruments (3) Kraft auf das Modul übertragen, um das Modul in die Vertiefung zu drücken, ohne dass Kraft auf die Ecken des Moduls ausgeübt wird.

8. Verfahren nach Anspruch 7, wobei das Modul vor dem Einsetzen in den Datenträger wärmebehandelt wird.

9. Verfahren nach Anspruch 8, wobei die Wärmebehandlung das Blasen von erhitzter Luft über die Oberfläche des Moduls, das in Kontakt mit dem Datenträger kommen soll, umfasst.

10. Verfahren nach einem der Ansprüche 7 bis 9, welches das Blasen eines Gases auf die Oberfläche des Moduls umfasst, bevor das Modul von dem Saugnapf berührt wird, um Schmutz von der Oberfläche des Moduls zu entfernen.

## Revendications

1. Outil (3) destiné à insérer un module (1) dans un support de données, dans lequel ledit outil est pourvu d'une face (4) comportant une ventouse (5) disposée dans la région centrale de ladite face, **caractérisé en ce que** ladite face comporte aussi une pluralité de zones surélevées (7) placées autour de ladite ventouse qui peuvent pousser, jusque dans une position sur un support de données, un module qui est tenu sur la face.

2. Outil (3) selon la revendication 1, dans lequel la face (4) de l'outil est prévue sous forme d'une face rectangulaire se conformant aux dimensions du module à insérer.

3. Outil (3) selon la revendication 1 ou la revendication 2, dans lequel la face (4) est d'une forme pratiquement rectangulaire.

4. Outil (3) selon la revendication 3, dans lequel les zones surélevées (7) sont placées à un emplacement pratiquement équidistant entre les coins d'un bord périphérique (4a) de la face de forme rectangulaire (4).

5. Outil (3) selon la revendication 4, dans lequel les zones surélevées (7) ont la forme de zones surélevées semi-circulaires, chaque zone surélevée ayant un bord rectiligne qui est aligné avec le bord périphérique (4a) de la face (4) et dans lequel le bord semi-circulaire des zones surélevées s'étend dans la face en direction de la ventouse (5).

6. Outil (3) selon l'une quelconque des revendications précédentes, dans lequel la ventouse (5) est faite d'une matière résistant à la chaleur, en particulier d'une matière du type silicone.

7. Procédé d'incorporation d'un module dans un support de données, ledit support de données ayant un évidement qui est formé dans une face du support de données, dans lequel ledit module est retiré d'un support de module en utilisant un outil (3) selon la revendication 1 comportant une ventouse (5) qui tient le module, l'outil (3) est amené à proximité de l'évidement, **caractérisé en ce que** la ventouse tient le module en position dans l'évidement du support de données et **en ce que** les zones surélevées de l'outil (3) placées autour de la ventouse transmettent une force au module pour pousser ledit module dans l'évidement sans qu'une force soit appliquée aux coins du module.

8. Procédé selon la revendication 7, dans lequel le module est traité thermiquement avant d'être inséré dans le support de données.

9. Procédé selon la revendication 8, dans lequel le traitement thermique implique le soufflage d'air chaud sur la surface du module qui est destinée à venir en contact avec le support de données.

10. Procédé selon l'une quelconque des revendications 7 à 9, impliquant le soufflage d'un gaz sur la surface du module avant que ledit module soit contacté par la ventouse pour éliminer d'éventuels débris de la surface du module.
